# FASCICULE DE BREVET EUROPEEN

(11) **EP 3 433 932 B1**
(45) Date de publication et mention de la délivrance du brevet: **01.04.2020**
(21) Numéro de dépôt: 17701155.8
(22) Date de dépôt: 25.01.2017
(51) Int. Cl.: H03K 17/97, A63B 71/06, G01L 1/14, G04F 8/08, G07C 1/22, H03K 17/972, H01L 41/12, A63B 69/12

(54) **CAPTEUR DE FORCE, NOTAMMENT POUR UNE PLAQUE DE TOUCHE**
KRAFTSENSOR, INSBESONDERE FÜR EINE BERÜHRUNGSEMPFINDLICHE PLATTE
FORCE SENSOR, IN PARTICULAR FOR A TOUCHPAD

(30) Priorité: 24.03.2016 EP 16162292
(43) Date de publication de la demande: 30.01.2019
(73) Titulaire: The Swatch Group Research and Development Ltd, 2074 Marin (CH)
(72) Inventeur: GUEISSAZ, François, 2036 Cormondrèche (CH)
(74) Mandataire: ICB SA
(86) Numéro de dépôt international: PCT/EP2017/051515
(87) Numéro de publication internationale: WO 2017/162352

(56) Documents cités:
- EP-A2- 0 207 512
- EP-A2- 2 267 415
- DE-B3- 10 304 595
- FR-A- 1 177 499
- US-A- 3 588 875
- US-A- 3 676 696
- US-A- 5 524 490
- US-A1- 2012 262 263

## Description

### Domaine de l'invention

L'invention se rapporte à un capteur adapté pour détecter une force exercée sur une plaque, appelée plaque de touche, d'un système de chronométrage de nageurs. Un tel capteur peut aussi être considéré comme un détecteur d'un déplacement de la plaque dû à l'application de la force. Naturellement, bien que le capteur de force / de déplacement soit particulièrement adapté pour l'usage précité, il convient à tous types d'applications nécessitant la détection d'une force ou d'un déplacement.

### Arrière-plan de l'invention

Classiquement, une plaque de touche est fixée au mur d'arrivée d'une ligne d'eau ou couloir d'un bassin de natation. Lorsqu'un nageur y exerce une pression détectée par un capteur de force, un chronomètre mesurant le temps du nageur s'arrête ou enregistre un temps intermédiaire.

On connait de la demande US 3,584,169 des capteurs de force adaptés pour cette utilisation. Cette demande décrit des capteurs de force sous la forme de câbles s'étendant le long de la plaque, entre la plaque et le mur d'arrivée. Chaque câble comprend deux lames métalliques en vis-à-vis, dont l'une est incurvée afin d'éviter tout contact entre les deux lames.

Lorsqu'un nageur exerce une force sur la plaque en direction du mur d'arrivée, au moins une portion d'un des câbles est compressée, les lames métalliques dudit câble venant alors en contact l'une de l'autre. Un circuit électrique de détection comprenant le câble se ferme alors.

Un inconvénient de ce type de capteurs est qu'il ne permet pas de localiser l'endroit de la plaque sur lequel le nageur a exercé une pression. Un autre inconvénient est qu'une force importante doit être exercée pour la plaque afin de mettre en contact les lames métalliques.

Il existe alors un besoin de capteurs de force plus sensibles et pouvant être positionnés sous forme matricielle sur ou en regard de la plaque pour permettre une localisation de l'impact d'un nageur.

Naturellement, de tels capteurs doivent également présenter un temps de réaction faible, de sorte à permettre un chronométrage précis des nageurs. De plus, de tels capteurs de force doivent être compacts, de faible épaisseur, être submersibles, et résistants aux chocs et aux agents potentiellement corrosifs présents dans l'eau de piscine ou bassin de natation, tels le chlore.

Un bouton-poussoir à détection magnétique est divulgué dans le document FR 1177499.

### Résumé de l'invention

Le but de la présente invention est de répondre en tout ou partie aux besoins évoqués précédemment.

A cet effet, l'invention se rapporte à un capteur de force comprenant :
- une première partie comportant une bobine de détection
- une deuxième partie positionnée en vis-à-vis de la première partie, et comportant :
   ∘ une plaquette ferromagnétique mobile en translation relativement à la première partie de sorte à s'en rapprocher lorsqu'une force est transmise au capteur et faire diminuer la réluctance d'un circuit magnétique composé desdites deux parties en série avec un entrefer variable
   ∘ un circuit électronique de détection configuré pour générer un signal dépendant de la réluctance du circuit magnétique,
   la plaquette ferromagnétique étant constituée d'un alliage métallique amorphe.

Par « la plaquette est mobile en translation relativement à la première partie », on entend que la plaquette est mobile en translation dans un référentiel dans lequel la première partie est fixe. Il est donc fait référence à des mouvements relatifs entre la plaquette et la première partie. Un tel référentiel n'est pas nécessairement un référentiel terrestre. En effet, la plaquette peut tout à fait être fixe dans un référentiel terrestre, et la première partie mobile.

Lorsque le capteur selon l'invention est placé entre un mur d'arrivée d'un bassin de natation et une plaque de touche, une force exercée sur la plaque à proximité du capteur se répercute sur ledit capteur. Cette force entraine un déplacement de la plaquette relativement à la première partie comportant la bobine de détection. Il s'ensuit une modification de la longueur de l'entrefer du circuit magnétique, à l'origine d'une variation de réluctance dudit circuit magnétique.

Ainsi, au moyen du circuit électronique de détection branché aux bornes de la bobine et permettant de générer un signal de sortie dépendant de la réluctance du circuit magnétique (dépendant de l'entrefer), il est possible de déterminer si la plaque a subi une force (c'est-à-dire si elle s'est déplacée, ou suffisamment pour que cela soit détecté).

Avantageusement, plusieurs capteurs selon l'invention sont répartis au sein de l'espace entre le mur d'arrivée et la plaque, par exemple sous forme matricielle, afin de déterminer à quel endroit un nageur a impacté la plaque. Plus le nombre de capteurs est élevé, plus la précision de la localisation est élevée.

De plus, le capteur de force selon l'invention est tel que la plaquette ferromagnétique est constituée d'un alliage métallique amorphe. L'utilisation de métal amorphe pour la plaquette présente de nombreux avantages.

En particulier, le métal amorphe présente une très grande perméabilité magnétique relative, de l'ordre de 1'000'000. En particulier, la famille des alliages amorphes cobalt-fer-nickel-bore-silicium présente de très grandes perméabilités magnétiques relatives, de l'ordre de 1'000'000. Or la réluctance du circuit magnétique est égale à la somme des réluctances des segments formés par la première partie (f), la plaquette (m), et l'entrefer (e), soit L_{f}/µ₀µ_{f}S_{f} + Lₘ/µ₀µₘS_{m +} Lₑ/µ₀Sₑ, où L représente la longueur du segment de circuit magnétique, µ sa perméabilité magnétique relative, S sa section, et µ₀ la perméabilité magnétique du vide. Pour augmenter la dépendance de la réluctance du circuit à l'entrefer, et ainsi la sensibilité du capteur, il est donc nécessaire de minimiser la somme des réluctances des pièces solides L_{f}/µ₀µ_{f}S_{f} + Lₘ/µ₀µₘSₘ par rapport à la réluctance de l'entrefer Lₑ/µ₀Sₑ. L'utilisation d'une plaquette de métal amorphe, qui possède une très haute perméabilité magnétique relative de l'ordre de 1'000'000, permet de diminuer la contribution de la réluctance de la plaquette.

De plus, en choisissant un matériau de forte perméabilité magnétique relative pour la première partie (hors bobine de détection), par exemple une ferrite possédant une haute perméabilité magnétique relative de l'ordre de 10'000, il est possible d'approximer la réluctance totale du circuit magnétique par celle de l'entrefer Lₑ/µ₀Sₑ.

Le métal amorphe présente également un faible trainage magnétique. Au sein de la plaquette, un champ magnétique induit s'établit donc rapidement après une excitation de la bobine de détection. Dans un mode de réalisation préféré, la mesure de variation de réluctance du circuit magnétique est réalisée à l'aide d'impulsions courtes périodiquement appliquées à la bobine placée dans le circuit magnétique à réluctance variable. Les variations de réluctance sont détectables à chaque nouvelle impulsion. Grâce au faible trainage magnétique du métal amorphe, il est possible d'implémenter un train d'impulsions de durées inférieures à quelques centaines de nanosecondes, à une fréquence de plus de 10'000 Hertz. Ceci correspond à un temps de latence du capteur inférieur à 100 microsecondes, permettant de réaliser un chronométrage précis des nageurs. De plus, chaque impulsion représente une dépense énergétique inférieure au nanojoule, soit une consommation inférieure à 10 microwatts. La consommation d'un ensemble de capteurs sur une plaque de touche est donc limitée. On note que l'utilisation d'un train d'impulsions courtes permet principalement de diminuer la consommation de courant.

En outre, le capteur de force selon l'invention peut comprendre une ou plusieurs des caractéristiques ci-dessous, selon toutes les combinaisons techniquement possibles.

Selon un mode de réalisation non limitatif, la plaquette est constituée d'un alliage métallique amorphe du type 2714A à base de cobalt-fer-nickel-bore-silicium (Co69Fe4Ni1B4Si15).

Selon un mode de réalisation non limitatif, la plaquette en métal amorphe présente une épaisseur comprise entre 20 et 200 micromètres, et notamment une épaisseur comprise entre 50 et 75 micromètres. En pratique, la plaquette en métal amorphe est éventuellement constituée de plusieurs feuilles minces superposées, pour atteindre l'épaisseur souhaitée. Plus l'épaisseur est élevée, plus les fuites magnétiques au niveau de la plaquette sont faibles, et plus le champ magnétique au sein de la plaquette est important. En revanche, une épaisseur élevée implique un capteur encombrant, ce qui est contraignant dans le cadre d'une utilisation du capteur pour chronométrer des nageurs. Il a été constaté expérimentalement qu'une épaisseur comprise entre 20 et 200 micromètres, et plus particulièrement entre 50 et 75 micromètres, est un bon compromis pour un capteur compact et présentant des fuites magnétiques faibles.

Selon un mode de réalisation non limitatif, la première partie comprend un noyau en ferrite, la bobine étant placée dans ledit noyau. Comme expliqué précédemment, la ferrite possède une haute perméabilité magnétique relative de l'ordre de 10'000, ce qui permet de diminuer la contribution de la réluctance de la première partie. On note que le noyau pourrait alternativement être réalisé en métal amorphe ferromagnétique.

Selon un mode de réalisation non limitatif, la bobine et le noyau sont sensiblement plats. On parle ici de bobine plate, ou bobine galette, en opposition à une bobine longue ou solénoïde. Ce type de bobines permet de limiter l'encombrement du capteur.

Selon un mode de réalisation non limitatif, la deuxième partie comprend une base fixée à la première partie, la base comportant des moyens de suspension solidaires de la plaquette en métal amorphe, la plaquette en métal amorphe étant mobile relativement à la première partie par l'intermédiaire desdits moyens de suspension. Le capteur forme alors un bloc dont une partie est mobile. Dans un mode de réalisation, la première partie est fixée à la plaque du système de chronométrage, en vis-à-vis du mur du bassin de natation. Lorsque la plaque se rapproche du mur par pression d'un nageur, le capteur est compressé et la plaquette en métal amorphe se rapproche de la première partie. Alternativement, la première partie est fixée au bassin de natation, la deuxième partie est fixée à la plaque, ou encore la deuxième partie est fixée au bassin de natation.

Selon un mode de réalisation non limitatif, les moyens de suspension sont des bras formés par découpe dans la base, chaque bras comprenant une extrémité comportant un plot, les plots étant fixés à la première partie. Il s'agit d'un moyen simple de former des moyens de suspensions. Les plots servent de points d'appui contre la première partie, le reste de la seconde partie est suspendu. Alternativement, les moyens de suspension pourraient être des ressorts attachés d'une part à la base, d'autre part à la première partie.

Selon un mode de réalisation non limitatif, la première partie comprend des moyens de scellement et une structure comprenant une cavité, la bobine et le circuit de détection étant enfermés au sein de la cavité par les moyens de scellement. Ainsi, la bobine et le circuit de détection sont protégés des chocs et de l'eau.

Selon un mode de réalisation non limitatif, les moyens de scellement sont une plaque en verre ou en céramique fixée (soudée ou collée, par exemple) à la structure. Avec ces matériaux, les flux magnétiques entre la première et la deuxième partie du capteur ne sont pas perturbés. De plus, le verre et la céramique, ou d'autres matériaux inorganiques cristallins, sont des matériaux résistants à l'eau et aux agents corrosifs tels le chlore, contrairement par exemple à un matériau organique comme le caoutchouc qui se détériorerait avec le temps.

L'invention concerne également un système de chronométrage de nageurs, comprenant une plaque positionnée au niveau d'un mur d'arrivée d'un bassin de natation, et au moins un capteur selon l'invention positionné entre le mur d'arrivée et la plaque de sorte qu'une force exercée sur la plaque soit transmise au capteur comprenant la plaquette en métal amorphe.

Dans un mode de réalisation non limitatif, le système de chronométrage comporte une pluralité de capteurs disposés sous forme matricielle entre le mur d'arrivée et la plaque. Ainsi, en fonction du/des capteur(s) qui réagi(ssen)t, il est possible de localiser l'impact du nageur sur la plaque.

### Description sommaire des dessins

D'autres particularités et avantages ressortiront clairement de la description qui en est faite ci-après, à titre indicatif et nullement limitatif, en référence aux dessins annexés, dans lesquels :
- la figure 1 est une vue en coupe d'un assemblage d'une première partie et d'une deuxième partie d'un capteur de force selon un mode de réalisation de l'invention
- la figure 2 représente la première partie seule
- la figure 3 représente la deuxième partie seule.

### Description détaillée des modes de réalisation préférés

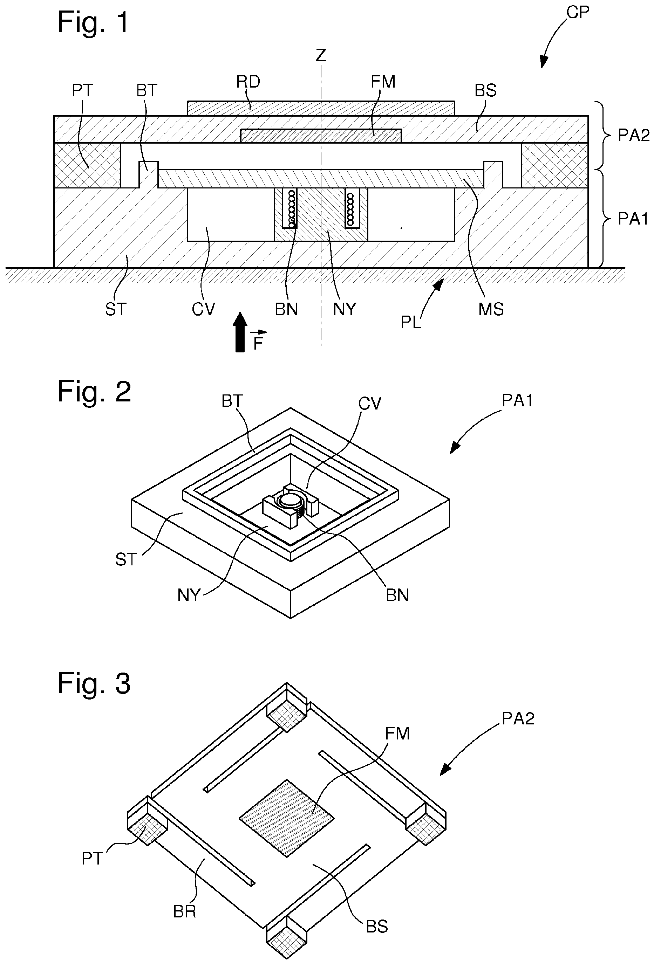

Comme cela est montré en référence à la figure 1, un capteur de force CP selon l'invention comporte :
- Une première partie PA1 comprenant notamment une bobine BN et un circuit de détection (non représenté) branché aux bornes de la bobine BN
- Une deuxième partie PA2 en vis-à-vis de la première partie PA1, comprenant notamment une plaquette ferromagnétique FM en alliage métallique amorphe, notamment du type 2714A à base de cobalt-fer-nickel-bore-silicium (Co69Fe4Ni1B4Si15).

Par en vis-à-vis, on entend que le plan R selon lequel s'étend la plaquette en métal amorphe FM est sensiblement orthogonal à l'axe Z de la bobine BN.

Dans le mode de réalisation montré à la figure 1, la première partie PA1 et la deuxième partie PA2 sont fixées l'une à l'autre. Plus précisément, et comme cela est expliqué en détails plus loin, la deuxième partie PA2 comporte des moyens de suspension BR, PT qui sont fixés à la première partie PA1. Par l'intermédiaire de ces moyens de suspension BR, PT, la plaquette en métal amorphe FM est maintenue en suspension relativement à la bobine BN. La plaquette en métal amorphe FM est alors apte à se déplacer en translation relativement à la première partie PA1 selon l'axe Z de la bobine BN, ce qui lui permet de se rapprocher ou de s'éloigner de la bobine BN. On rappelle que par « la plaquette est mobile en translation relativement à la première partie », on entend que la plaquette est mobile en translation dans un référentiel dans lequel la première partie est fixe, ce référentiel n'étant pas nécessairement un référentiel terrestre (dans un référentiel terrestre, la première partie peut tout à fait être mobile). Dans le cadre d'une utilisation de chronométrage de nageurs, le capteur CP est placé entre un mur d'arrivée d'une ligne d'un bassin de natation et une plaque PL d'un système de chronométrage. Le capteur CP est attaché soit au mur, soit à la plaque, au niveau de la première partie PA1 ou au niveau de la deuxième partie PA2. Sur la figure 1 illustrant un exemple de réalisation non limitatif, le capteur CP est montré attaché à la plaque PL au niveau de sa première partie PA1. Lorsqu'une force F, montrée à la figure 1, est appliquée sur la plaque PL, la plaque PL se rapproche du mur, comprimant le capteur CP. La plaquette en métal amorphe FM et la bobine BN se rapprochent alors l'une de l'autre via les moyens de suspension BR, PT.

Dans un mode de réalisation alternatif, la première partie PA1 et la deuxième partie PA2 ne sont pas fixées l'une à l'autre. La première partie PA1 est donc complètement mobile relativement à la deuxième partie PA2. Dans le cadre d'une utilisation de chronométrage de nageurs, la première partie PA1 est fixée à la plaque et la deuxième partie PA2 est fixée en vis-à-vis au mur, ou inversement. Lorsqu'une force est appliquée sur la plaque PL, la plaque PL se rapproche du mur, rapprochant la première partie PA1 de la deuxième partie PA2. On note que dans ce mode de réalisation, la deuxième partie PA2 pourrait ne pas comprendre de moyens de suspension BR, PT, et que si la deuxième parie PA2 en comporte, alors ces moyens de suspension ne sont pas fixés à la première partie PA1.

Les figures 2 et 3 montrent respectivement la première partie PA1 et la deuxième partie PA2.

Comme on le voit aux figures 1 et 2, la première partie PA1 comporte une structure ST à section sensiblement carrée (mais qui pourrait être de forme différente), au centre de laquelle est creusée une cavité CV. Dans la cavité CV est positionnée la bobine BN, ainsi qu'un noyau ferromagnétique NY pour la bobine BN. Le noyau NY est par exemple constitué de ferrite, ou d'un assemblage de feuilles de tôles. Alternativement, le noyau NY est constitué de métal amorphe, qui est mécaniquement plus résistant aux déformations élastiques que les matériaux précités.

Tel que représenté à la figure 1, la première partie PA1 comporte des moyens de scellement MS de la cavité CV. Le circuit électronique de détection et la bobine BN étant placés dans la cavité CV, il est important de garantir l'étanchéité de cette dernière. Toutefois, les moyens de scellement MS ne doivent pas perturber les champs magnétiques. De plus, les moyens de scellement MS doivent être résistants à l'usure. Des moyens de scellement MS constitués d'une plaque en verre ou en céramique répondent à ces contraintes. La plaque MS est par exemple soudée, brasée, chassée avec ou sans joint, ou collée aux parois adjacentes de la cavité CV, de sorte à la refermer.

Comme cela est visible aux figures 1 et 3, la deuxième partie PA2 comporte une base BS de section carrée, au centre de laquelle est placée la plaquette en métal amorphe FM. On note que l'épaisseur de la base BS doit être suffisante pour résister aux pressions maximales exercées sur le capteur. Par exemple, l'épaisseur est de 1,4 millimètre, et les deux autres dimensions sont de 25 millimètres. Par ailleurs, la plaquette en métal amorphe FM est également sensiblement carrée, et est fixée au centre de la base BS. Naturellement, la base BS et la plaquette métallique FM pourraient prendre d'autres formes arbitraires.

Comme évoqué précédemment, la base BS comporte des moyens de suspension BR, PT aptes à se déformer lorsqu'une force F est appliquée sur la base BS orthogonalement à la plaquette en métal amorphe FM. Cette déformation permet une translation de la plaquette en métal amorphe FM selon l'axe Z de la bobine BN. Dans l'exemple illustré, les moyens de suspension BR, PT sont constituées de quatre bras BR formés par usinage (au laser, par exemple) dans la base BS, chacun des bras BR s'étendant le long d'un des bords de la base BS et comportant un plot PT à une de ses extrémités. Naturellement, d'autres types de moyens de suspension pourraient être utilisés, par exemple des ressorts.

Dans un mode de réalisation, la base BS comporte en outre une plaque de rigidification RD, placée du côté opposé aux plots PT, et permettant de renforcer la zone sur laquelle se trouve la plaquette en métal amorphe FM.

Les moyens de scellement MS étant naturellement fragiles et cassants, il est nécessaire de limiter ou d'éviter entièrement la force d'appui de la plaquette en métal amorphe FM et de la base BS sur ceux-ci. Pour ce faire, les moyens de scellement MS sont confinés à l'intérieur d'une butée BT, formée dans la structure ST, dont la hauteur est légèrement supérieure à l'épaisseur des moyens de scellement MS afin de ne pas imposer un entrefer minimum trop élevé. La position et la largeur de la butée BT sont agencées de manière à permettre un recouvrement minimum des moyens de scellement MS au-delà de la cavité CV, et d'éviter un contact entre la butée BT et les bras de flexion BR.

Bien entendu, la présente invention ne se limite pas à l'exemple illustré mais est susceptible de diverses variantes et modifications qui apparaîtront à l'homme de l'art.

## Revendications

1. Capteur de force (CP) comprenant :
- une première partie (PA1) comportant une bobine de détection (BN)
- une deuxième partie (PA2) positionnée en vis-à-vis de la première partie (PA1), et comportant :
∘ une plaquette ferromagnétique (FM) mobile en translation relativement à la première partie (PA1) de sorte à s'en rapprocher lorsqu'une force (F) est transmise au capteur (CP) et faire diminuer la réluctance d'un circuit magnétique composé desdites deux parties (PA1, PA2) en série avec un entrefer variable
∘ un circuit électronique de détection configuré pour générer un signal dépendant de la réluctance du circuit magnétique,
**caractérisé en ce que** la plaquette ferromagnétique (FM) est constituée d'un alliage métallique amorphe.

2. Capteur de force (CP) selon la revendication précédente, la plaquette ferromagnétique (FM) présentant une épaisseur comprise entre 20 et 200 micromètres, et notamment entre 50 et 75 micromètres.

3. Capteur de force (CP) selon l'une des revendications précédentes, la première partie (PA1) comprenant un noyau en ferrite, la bobine (BN) étant placée dans ledit noyau (NY).

4. Capteur de force (CP) selon la revendication précédente, la bobine (BN) et le noyau (NY) étant sensiblement plats.

5. Capteur de force (CP) selon l'une des revendications précédentes, la deuxième partie (PA2) comprenant une base (BS) comprenant des moyens de suspension (BR, PT) solidaires de la plaquette ferromagnétique (FM).

6. Capteur de force (CP) selon la revendication précédente, les moyens de suspension (BR, PT) étant fixés à la première partie (PA1), la plaquette ferromagnétique (FM) étant mobile en translation relativement à la première partie (PA1) par l'intermédiaire desdits moyens de suspension (BR, PT).

7. Capteur de force (CP) selon l'une des revendications 5 ou 6, les moyens de suspension (BR, PT) comprenant :
- des bras (BR) formés par découpe dans la base (BS), chaque bras (BR) comportant une extrémité
- des plots (PT), tels qu'un plot (PT) est fixé à chaque extrémité d'un bras (BR).

8. Capteur de force (CP) selon l'une des revendications précédentes, la première partie (PA1) comprenant des moyens de scellement (MS) et une structure (ST) comprenant une cavité (CV), la bobine (BN) et le circuit de détection étant enfermés au sein de la cavité (CV) par les moyens de scellement (MS).

9. Capteur de force (CP) selon la revendication précédente, les moyens de scellement (MS) étant une plaque en verre, en céramique, ou en un autre matériau inorganique cristallin, fixée à la structure (ST).

10. Capteur de force (CP) selon la revendication précédente, la structure (ST) présentant une butée (BT) encadrant la cavité (CV), la butée (BT) présentant une hauteur supérieure à l'épaisseur de la plaque des moyens de scellement (MS), préférentiellement au maximum de 10% supérieure.

11. Système de chronométrage de nageurs, comprenant une plaque de touche (PL) positionnée au niveau d'un mur d'arrivée d'un bassin de natation, et au moins un capteur (CP) selon l'une des revendications précédentes, ledit capteur (CP) étant positionné entre le mur d'arrivée et la plaque de touche (PL) de sorte qu'une force (F) exercée sur la plaque de touche (PL) soit transmise à la plaquette ferromagnétique (FM).

12. Système de chronométrage selon la revendication précédente, comprenant une pluralité de capteurs (CP) selon l'une des revendications précédentes, disposés sous forme matricielle entre le mur d'arrivée et la plaque de touche (PL).

## Patentansprüche

1. Kraftsensor (CP), umfassend:
- ein erstes Teil (PA1) mit einer Erfassungsspule (BN),
- ein zweites Teil (PA2), das gegenüber dem ersten Teil (PA1) positioniert ist und umfasst:
∘ eine ferromagnetische Platte (FM), die in Bezug auf das erste Teil (PA1) translatorisch beweglich ist, derart, dass sie sich diesem annähert, wenn eine Kraft (F) auf den Sensor (CP) übertragen wird, und eine Verringerung der Reluktanz eines aus den beiden Teilen (PA1, PA2) in Reihe mit einem veränderlichen Luftspalt zusammengesetzten Magnetkreises bewirkt, und
∘ eine elektronische Erkennungsschaltung, die so konfiguriert ist, dass sie ein von der Reluktanz des Magnetkreises abhängiges Signal erzeugt,
**dadurch gekennzeichnet, dass** die ferromagnetische Platte (FM) aus einer amorphen Metalllegierung gebildet ist.

2. Kraftsensor (CP) nach dem vorhergehenden Anspruch, wobei die ferromagnetische Platte (FM) eine Dicke im Bereich von 20 bis 200 Mikrometern und insbesondere von 50 bis 75 Mikrometern aufweist.

3. Kraftsensor (CP) nach einem der vorhergehenden Ansprüche, wobei das erste Teil (PA1) einen Ferritkern aufweist und die Spule (BN) in dem Kern (NY) angeordnet ist.

4. Kraftsensor (CP) nach dem vorhergehenden Anspruch, wobei die Spule (BN) und der Kern (NY) im Wesentlichen flach sind.

5. Kraftsensor (CP) nach einem der vorhergehenden Ansprüche, wobei das zweite Teil (PA2) eine Basis (BS) mit Aufhängungsmitteln (BR, PT) umfasst, die mit der ferromagnetischen Platte (FM) fest verbunden sind.

6. Kraftsensor (CP) nach dem vorhergehenden Anspruch, wobei die Aufhängungsmittel (BR, PT) am ersten Teil (PA1) befestigt sind und wobei die ferromagnetische Platte (FM) in Bezug auf das erste Teil (PA1) über die Aufhängungsmittel (BR, PT) translatorisch beweglich ist.

7. Kraftsensor (CP) nach einem der Ansprüche 5 oder 6, wobei die Aufhängungsmittel (BR, PT) umfassen:
- Arme (BR), die durch Einschneiden in die Basis (BS) gebildet sind, wobei jeder Arm (BR) ein Ende aufweist,
- Klötzchen (PT), derart, dass ein Klötzchen (PT) an jedem Ende eines Arms (BR) befestigt ist.

8. Kraftsensor (CP) nach einem der vorhergehenden Ansprüche, wobei das erste Teil (PA1) Dichtungsmittel (MS) und eine Struktur (ST) mit einem Hohlraum (CV) umfasst, wobei die Spule (BN) und die Erfassungsschaltung in dem Hohlraum (CV) durch die Dichtungsmittel (MS) eingeschlossen sind.

9. Kraftsensor (CP) nach dem vorhergehenden Anspruch, wobei die Dichtungsmittel (MS) eine an der Struktur (ST) befestigte Platte aus Glas, Keramik oder einem anderen kristallinen anorganischen Material sind.

10. Kraftsensor (CP) nach dem vorhergehenden Anspruch, wobei die Struktur (ST) einen Anschlag (BT) aufweist, der den Hohlraum (CV) umgibt, wobei der Anschlag (BT) eine Höhe aufweist, die größer ist als die Dicke der Platte der Dichtungsmittel (MS), vorzugsweise höchstens 10 % größer.

11. Zeitmesssystem für Schwimmer, umfassend eine berührungsempfindliche Platte (PL), die auf Höhe einer Ankunftswand eines Sportschwimmbeckens positioniert ist und mindestens einen Sensor (CP) nach einem der vorhergehenden Ansprüche umfasst, wobei der Sensor (CP) zwischen der Ankunftswand und der berührungsempfindlichen Platte (PL) positioniert ist, so dass eine auf die berührungsempfindliche Platte (PL) ausgeübte Kraft (F) an die ferromagnetische Platte (FM) übertragen wird.

12. Zeitmesssystem nach dem vorhergehenden Anspruch, umfassend mehrere Sensoren (CP) nach einem der vorhergehenden Ansprüche, die matrixförmig zwischen der Ankunftswand und der berührungsempfindlichen Platte (PL) angeordnet sind.

## Claims

1. Force sensor (CP) comprising:
- a first part (PA1) comprising a detection coil (BN);
- a second part (PA2) positioned opposite the first part (PA1) and comprising:
∘ a ferromagnetic plate (FM) that is translationally movable relative to the first part (PA1) so as to move towards said part when a force (F) is transferred to the sensor (CP) and to reduce the reluctance of a magnetic circuit formed by said two parts (PA1, PA2) in series with a variable gap;
∘ an electronic detection circuit configured to generate a signal dependent on the reluctance of the magnetic circuit,
**characterised in that** the ferromagnetic plate (FM) is formed by an amorphous metal alloy.

2. Force sensor (CP) as claimed in the preceding claim, the thickness of the ferromagnetic plate (FM) being between 20 and 200 micrometres, and particularly between 50 and 75 micrometres.

3. Force sensor (CP) as claimed in any of the preceding claims, the first part (PA1) comprising a ferrite core, the coil (BN) being placed inside said core (NY).

4. Force sensor (CP) as claimed in the preceding claim, the coil (BN) and the core (NY) being substantially flat.

5. Force sensor (CP) as claimed in any of the preceding claims, the second part (PA2) comprising a base (BS) comprising suspension means (BR, PT) rigidly connected to the ferromagnetic plate (FM).

6. Force sensor (CP) as claimed in the preceding claim, the suspension means (BR, PT) being fixed to the first part (PA1), the ferromagnetic plate (FM) being translationally movable relative to the first part (PA1) by means of said suspension means (BR, PT).

7. Force sensor (CP) as claimed in either one of claims 5 or 6, the suspension means (BR, PT) comprising:
- arms (BR) formed by cutting in the base (BS), each arm (BR) comprising an end;
- contact pads (PT), such that a contact pad (PT) is fixed to each end of an arm (BR).

8. Force sensor (CP) as claimed in any of the preceding claims, the first part (PA1) comprising sealing means (MS) and a structure (ST) comprising a cavity (CV), the coil (BN) and the detection circuit being enclosed inside the cavity (CV) by the sealing means (MS).

9. Force sensor (CP) as claimed in the preceding claim, the sealing means (MS) being a plate that is made of glass, ceramic or another crystalline inorganic material and fixed to the structure (ST).

10. Force sensor (CP) as claimed in the preceding claim, the structure (ST) having a stop (BT) framing the cavity (CV), the height of the stop (BT) being greater than the thickness of the plate of the sealing means (MS), preferably a maximum of 10 % greater.

11. Swimmer timing system, comprising a touch pad (PL) positioned on a finishing wall of a swimming pool and at least one sensor (CP) as claimed in any of the preceding claims, said sensor (CP) being positioned between the finishing wall and the touch pad (PL) so that a force (F) exerted on the touch pad (PL) is transferred to the ferromagnetic plate (FM).

12. Timing system as claimed in the preceding claim, comprising a plurality of sensors (CP) as claimed in any of the preceding claims, arranged in matrix form between the finishing wall and the touch pad (PL).
